# EUROPÄISCHE PATENTSCHRIFT

(11) **EP 1 490 528 B1**
(45) Veröffentlichungstag und Bekanntmachung des Hinweises auf die Patenterteilung: **29.06.2005**
(21) Anmeldenummer: 03720208.2
(22) Anmeldetag: 19.03.2003
(51) Int. Cl.: C23C 14/34, H01J 37/34

(54) **DREHBARE ROHRKATHODE**
ROTATING TUBULAR CATHODE
CATHODE TUBULAIRE TOURNANTE

(30) Priorität: 22.03.2002 DE 10213049
(43) Veröffentlichungstag der Anmeldung: 29.12.2004
(73) Patentinhaber: WURCZINGER, Dieter, 61118 Bad Vilbel (DE)
(72) Erfinder: WURCZINGER, Dieter, 61118 Bad Vilbel (DE)
(74) Vertreter: Schickedanz, Willi, Dr. Dipl.-Ing.
(86) Internationale Anmeldenummer: PCT/DE2003/000903
(87) Internationale Veröffentlichungsnummer: WO 2003/080891

(56) Entgegenhaltungen:
- EP-A- 0 992 606
- US-A- 4 374 722
- US-A- 4 407 713
- US-A- 5 437 778

## Beschreibung

Die Erfindung betrifft eine Rohrkathode nach dem Oberbegriff des Patentanspruchs 1.

Für die Beschichtung von Substraten größerer Ausdehnung, z. B. Fensterglas oder Windschutzscheiben, werden schon seit geraumer Zeit Sputteranlagen eingesetzt, die planare Magnetrons aufweisen.

Wegen der großen Flächen, die beschichtet werden müssen, haben die Sputteranlagen große Ausmaße.

Anstelle von planaren Magnetrons sind auch schon rotierende zylindrische Magnetrons für den Einsatz in Sputteranlagen vorgeschlagen worden. Bei dem Rotationsmagnetron ist das zu sputternde Material - Target genannt - als Rohrform ausgebildet. Dabei dreht sich beim Sputtern das Targetrohr um in dem Rohr befindliche Magneten, welche die Rotation des Targetrohrs nicht mitmachen. Der Vorteil von Rotationsmagnetrons gegenüber Planarmagnetrons besteht darin, dass sich statt einer Targetausbeute von nur ca. 20 % bis 40 % eine Ausbeute von etwa 90 % ergibt. Allerdings ist es nicht ganz einfach, ein zylindrisches Target im Hochvakuum zu drehen und außerdem eine Wasserkühlung und ein stationäres Magnetfeld vorzusehen. Insbesondere beim Magnetron- oder Kathodenwechsel treten Probleme auf, die darin bestehen, dass das Kühlwasser gegen Vakuum gedichtet werden muss, was bei rotierenden Systemen sehr schwierig ist.

Aus der EP 0 500 774 B1 ist bereits ein drehbares zylindrisches Magnetron mit einem Target bekannt, das eine Magnetkonstruktion aufweist, die sich über die volle Länge des Magnetrons erstreckt und die gegen ein Mitdrehen mit dem Target gesichert ist. Hierbei ist eine Mehrzahl von Rollen an der Magnetkonstruktion vorgesehen, die sich an einer Innenfläche des Targets abstützt. Die Kühlung erfolgt hierbei durch eine innerhalb der Targetkonstruktion angeordnete und über deren Länge verlaufende Kühlmittelleitung, die durch Verbindung mit dem Gehäuse der Vakuumkammer gegen eine Drehung festgelegt ist. Nachteilig ist hierbei, dass das Target selbst nur teilweise gekühlt wird.

Des Weiteren ist eine Sputtervorrichtung mit rotierendem Target und einer Wassertargetkühlung bekannt (DE 41 17 368 A1). Hierbei konzentriert sich die Kühlung auf den oder die Bereiche des Targets, der oder die sich während des Betriebs besonders erwärmen. So bilden beispielsweise die Magnete des Magnetrons wenigstens einen Kühlkanal der Sputtervorrichtung. Alternativ ist ein eigenes Kühlrohr vorgesehen, das mehrere Kühlkanäle aufweist und mit seiner Außenwand an die Innenwand des Targetträgers stößt. Die letztgenannte Alternative kühlt zwar das ganze Target und nicht nur die Magnete, doch ist es schwierig, ein neues Target mit Targetträger auf das Kühlrohr aufzuziehen.

Weiterhin ist eine Vorrichtung bekannt, mit der es möglich ist, ein drehbares zylindrisches Magnetrontarget mit einer Spindel zu verbinden (US 5 591 314). Mit Hilfe dieser Vorrichtung sollen die Nachteile bekannter Drehkathodeneinrichtungen beseitigt werden, die darin bestehen, dass Kühlwasserdurchbrüche an der Schnittstelle zwischen dem zylindrischen Magnetrontarget und der Antriebsspindel auftreten. Die Vorrichtung weist einen mit einem Gewinde versehenen Kragen auf, der in Windungen auf der Außenseite des Targets eingreift, wobei eine einzige Wasser-zu-Vakuum-Dichtung an der Schnittstelle zwischen Target und Spindel vorgesehen ist.

Der Erfindung liegt die Aufgabe zugrunde, den Austausch von Rohrkathoden in Sputteranlagen zu vereinfachen.

Diese Aufgabe wird gemäß den Merkmalen des Patentanspruchs 1 gelöst.

Hierbei wird die Kühlung des Targetrohrs über eine flexible, fluidgekühlte Folie durchgeführt, die sich von innen an das Targetrohr anlegt. Die Folie dichtet den Fluidkreislauf gegenüber dem Targetrohr ab und bildet somit ein geschlossenes System. Es ist hierbei kein direkter Fluid-Vakuum-Übergang vorhanden, der beim Targetwechsel montiert oder demontiert werden muss. Das verbrauchte Targetrohr wird werden kann. Mit 8 ist ein Gaszufluss bezeichnet, dem auf der gegenüberliegenden Seite der Vakuumkammer 1 ein nicht dargestellter Gasabfluss gegenüberliegt.

Die Rohrkathode 2 liegt am negativen Pol einer Spannungsquelle 9, die hier als Gleichspannungsquelle dargestellt ist. Der positive Pol der Spannungsquelle 9 ist mit dem Boden 7 der Vakuumkammer 1 verbunden. Es versteht sich, dass statt einer Gleichspannungsquelle auch eine Wechselspannungsquelle vorgesehen sein kann.

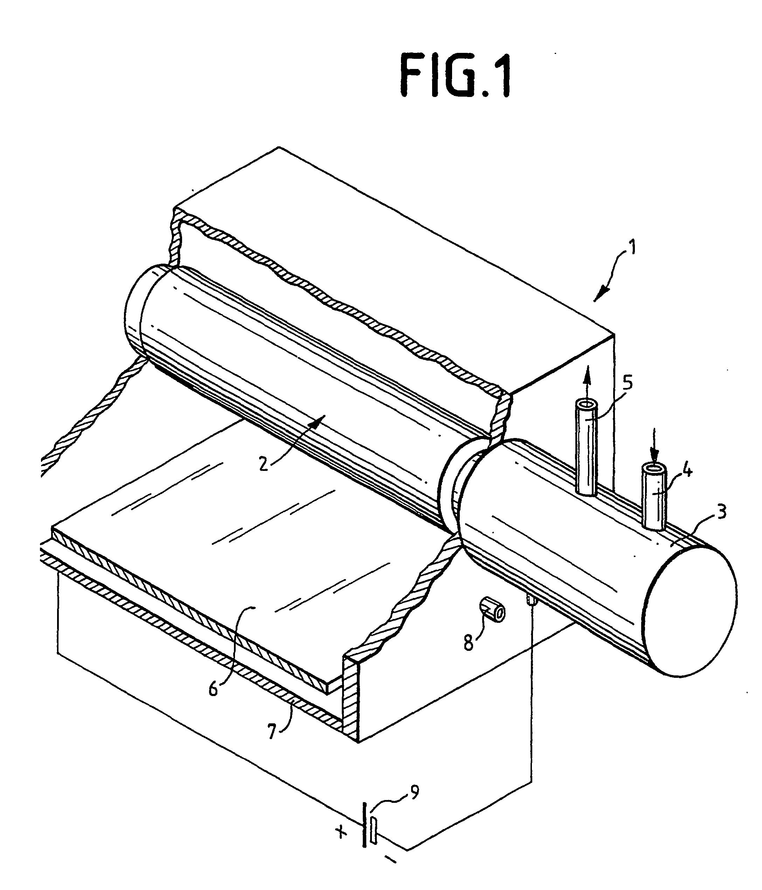

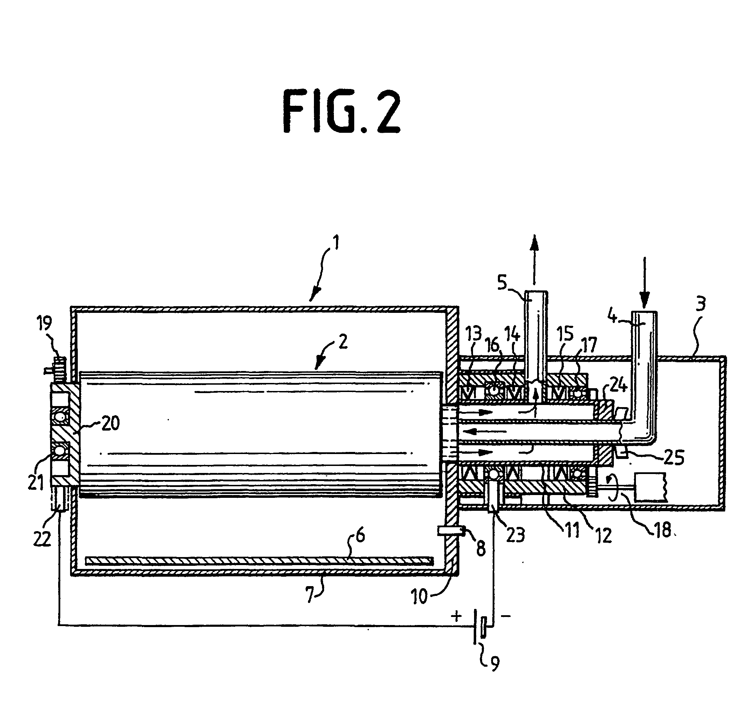

Die Fig. 2 zeigt die Vakuumkammer 1 in einem Längsschnitt. Hierbei erkennt man wieder die Rohrkathode 2, den Stutzen 3 mit dem Fluid-Zufluss 4 und den Fluid-Abfluss 5, das Substrat 6, den Boden 7, den Gaszufluss 8 und die Gleichspannungsquelle 9. Außerdem erkennt man eine Rezipientenwand 10. Diese Rezipientenwand 10 trennt das in die Vakuumkammer 1 herrschende Vakuum von der Atmosphäre, die den Stutzen 3 umgibt. In dem Stutzen 3 befindet sich ein Fluid-Rohr 11, das den Fluid-Zufluss 4 und den Fluid-Abfluss 5 umfasst. Koaxial um das Fluid-Rohr 11 herum befindet sich ein Rohr 12 aus einem elektrisch nicht leitenden Material. Zwischen den beiden Rohren 11 und 12 sind drei Dichtungsringe 13, 14, 15 und zwei Lagerungen 16, 17 angeordnet. Vor der Lagerung 17 befindet sich ein Drehantrieb 18, der die Rohrkathode 2 dreht. Ein weiterer Drehantrieb 19 ist am anderen Ende der Rohrkathode vorgesehen, wo ein Stutzen 20 der Rohrkathode 2 in einem Lager 21 ruht. Mit 22, 23 sind Stromzuführungen bezeichnet, an denen die Pole der Gleichspannungsquelle 9 liegen.

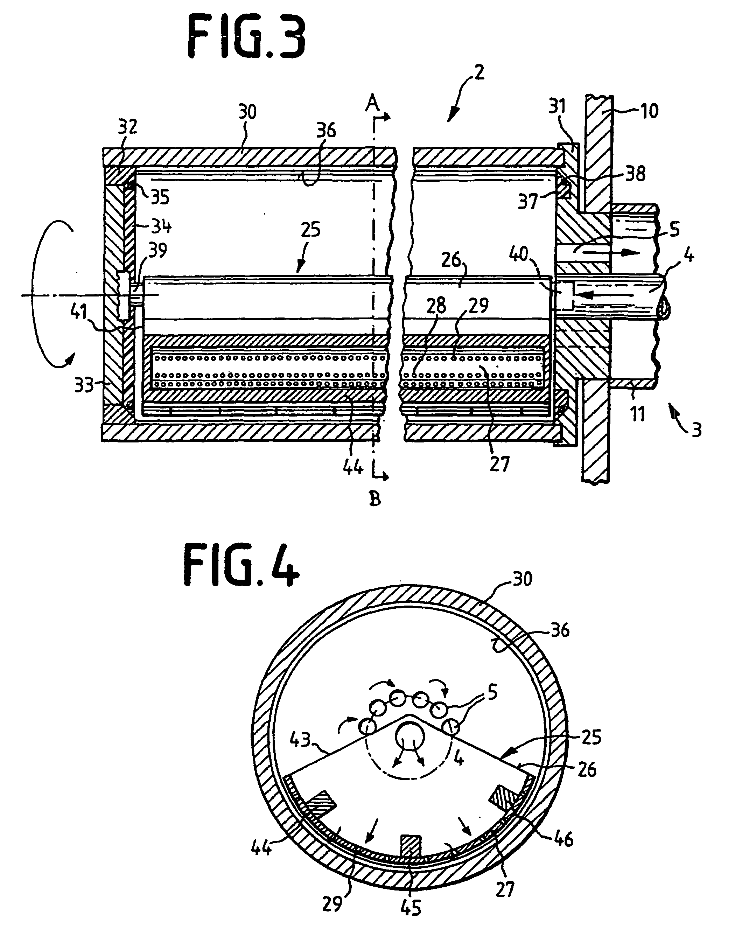

In der Fig. 3 ist die Vakuumkammer 1 weggelassen und im Wesentlichen nur das Targetrohr 2 im Schnitt dargestellt. Die Vakuumkammer 1 ist lediglich mit ihrer Rezipientenwand 10 angedeutet. Innerhalb des Targetrohrs 2 befindet sich ein Innenkörper 25, der zwei obere, schräg angeordnete Wände aufweist, von denen man in der Fig. 3 nur eine Wand 26 sieht. Unterhalb dieser schrägen Wand erkennt man eine kreisbogenförmige Wanne 27, die mit mehreren Löchern 28, 29 versehen ist.

Ein rohrförmiges Target 30 ist mit seinem einen Ende in einem Aufnahmeflansch 31 gelagert und ruht mit seinem anderen Ende auf einem Überwurfring 32, der einen Endflansch 33 umgibt. Vor dem Endflansch 33 befindet sich eine Dichtplatte 34, die mit einem Dichtring 35 versehen ist, der an eine elastische Folie 36 stößt, die zylindrisch ausgebildet ist und parallel zur Innenseite des Targets 30 verläuft. Mittels eines Dichtrings 37, der einen Gummiring 38 aufweist, ist die Folie 36 an ihrem anderen Ende eingeklemmt. Der Innenkörper 25 ist auf beiden Seiten mit jeweils einem Stutzen 39, 40 ortsfest gelagert, d. h. er macht die Drehbewegung des Targets 30 nicht mit. Die beidseitig eingeklemmte zylindrische Folie 36 ist das Kernstück der Erfindung. Wird das kühlende Fluid, z. B. Wasser, über den Einlass 4 - der bis kurz vor die Endwand 41 des Innenkörpers 25 reicht - in den Innenkörper gegeben, stößt es gegen diese Endwand 41 und fließt durch die Löcher der kreisbogenförmigen Wanne 27 nach unten auf die Folie 36. Mit zunehmender Menge des kühlenden Fluids steigt dieses immer mehr nach oben, bis es die Oberseite der Folie 36 erreicht. Der Liquid-Druck wird nun so groß, dass die Folie fest auf die Innenseite des Targets gedrückt wird. Hierdurch ist eine effektive Kühlung des Targets möglich.

Der Innenkörper 25 muss nicht zwangsläufig fest gelagert sein, vielmehr kann er auch über eine Kniehebelkonstruktion oder dergleichen, etwa beim Targetwechsel, geschwenkt werden.

In der Fig. 4 ist ein Querschnitt A-B durch die Rohrkathode 2 gezeigt. Man erkennt hierbei die kreisbogenförmige Wanne 27, die Wände 26, 43, den Zufluss 4 und den Abfluss 5. Der Abfluss 5 besteht hierbei aus mehreren auf einem Kreis liegenden Löchern. Auf der Innenseite der kreisbogenförmigen Wanne 27 sind drei Dauermagnete 44, 45, 46 angeordnet, die sich über die Länge des Targets 30 erstrecken.

Der Innenkörper 25 hat verschiedene Funktionen. So dient er dazu, eine gleichmäßige Verteilung des Fluids bei der Fluidaufnahme und -abgabe zu gewährleisten. Außerdem nimmt er die Magnete 44 bis 46 auf. Bei einer einseitigen Lagerung der Rohrkathode 2 fängt er zudem den Druck am Rohrende durch ein Gegenlager 39 auf.

Die flexible Folie 36 ist als durchgängig offener oder einseitig offener Schlauch ausgeführt und am jeweiligen Ende an einen Flansch 31, 33 durch ein Foliendichtsystem 32, 34, 33; 37, 38 abgedichtet. Damit ist die Folie montier- und austauschbar, und der Zugang zum Innenkörper 25 wird dadurch ermöglicht.

Beim Targetwechsel wird das Kühlfluid abgelassen, die Folie 36 ist entspannt und das Targetrohr 30 kann einfach abgezogen werden. Die Folie 36 kann aus verschiedenen Materialien bestehen, z. B. aus Gummi, Kunststoff, Metall, Grafit- oder Glasfaser oder aus Kombinationen dieser Materialien. Wesentlich ist, dass die Folie fluiddicht ist. Die Dichtung am Folienende kann geklebt, geschweißt, vulkanisiert oder über O-Ring ausgeführt sein.

Der Innenkörper 25 muss nicht zwangsläufig fest gelagert sein, vielmehr kann er auch über eine Kniehebelkonstruktion oder dergleichen, etwa beim Targetwechsel, geschwenkt werden.

In der Fig. 4 ist ein Querschnitt A-B durch die Rohrkathode 2 gezeigt. Man erkennt hierbei die kreisbogenförmige Wanne 27, die Wände 26, 42, den Zufluss 4 und den Abfluss 5. Der Abfluss 5 besteht hierbei aus mehreren auf einem Kreis liegenden Löchern. Auf der Innenseite der kreisbogenförmigen Wanne 27 sind drei Dauermagnete 44, 45, 46 angeordnet, die sich über die Länge des Targets 30 erstrecken.

Der Innenkörper 25 hat verschiedene Funktionen. So dient er dazu, eine gleichmäßige Verteilung des Fluids bei der Fluidaufnahme und -abgabe zu gewährleisten. Außerdem nimmt er die Magnete 44 bis 46 auf. Bei einer einseitigen Lagerung der Rohrkathode 2 fängt er zudem den Druck am Rohrende durch ein Gegenlager 39 auf.

Die flexible Folie 36 ist als durchgängig offener oder einseitig offener Schlauch ausgeführt und am jeweiligen Ende an einen Flansch 31, 33 durch ein Foliendichtsystem 32, 34, 33; 37, 38 abgedichtet Damit ist die Folie montier- und austauschbar, und der Zugang zum Innenkörper 25 wird dadurch ermöglicht.

Beim Targetwechsel wird das Kühlfluid abgelassen, die Folie 36 ist entspannt und das Targetrohr 30 kann einfach abgezogen werden. Die Folie 36 kann aus verschiedenen Materialien bestehen, z. B. aus Gummi, Kunststoff, Metall, Grafit- oder Glasfaser oder aus Kombinationen dieser Materialien. Wesentlich ist, dass die Folie fluiddicht ist Die Dichtung am Folienende kann geklebt, geschweißt, vulkanisiert oder über O-Ring ausgeführt sein.

## Patentansprüche

1. Drehbare Rohrkathode für eine Kathodenzerstäubung, wobei die Rohrkathode eine Fluid-Kühlung aufweist und das Fluid-Kühlungsmittel an der Innenwand eines Targets oder Targetträgers vorbeiströmt, **dadurch gekennzeichnet, dass** zwischen dem Targetträger bzw. dem Target (30) und der zentralen Längsachse der Rohrkathode (2) eine zylindrische und elastische Folie (36) vorgesehen ist.

2. Drehbare Rohrkathode nach Anspruch 1, **dadurch gekennzeichnet, dass** innerhalb des Targets (30) oder Targetträgers wenigstens ein stationärer Magnet (44) vorgesehen ist, der die Drehbewegungen der Rohrkathode (2) nicht mitmacht.

3. Drehbare Rohrkathode nach Anspruch 1, **dadurch gekennzeichnet, dass** die zylindrische und elastische Folie (36) einen Innenkörper (25) umgibt, über den ein Kühlmittel geführt ist.

4. Drehbare Rohrkathode nach Anspruch 1, **dadurch gekennzeichnet, dass** die zylindrische und elastische Folie (36) an ihren beiden Enden jeweils mit einem Flansch (31, 33) verbunden ist.

5. Drehbare Rohrkathode nach Anspruch 3, **dadurch gekennzeichnet, dass** der Innenkörper (25) einen kreisbogenförmigen Boden (27) aufweist, der mit Löchern (28, 29) zum Durchlass des Kühlmittels versehen ist.

6. Drehbare Rohrkathode nach Anspruch 5, **dadurch gekennzeichnet, dass** der kreisbogenförmige Boden (27) Magnete (44 bis 46) trägt.

7. Drehbare Rohrkathode nach Anspruch 3, **dadurch gekennzeichnet, dass** eine Kühlmittelzuführung (4) in Form eines Rohrs vorgesehen ist, die von der Atmosphärenseite kommend in den Innenkörper (25) gelangt und kurz vor einer Seitenwand (41) des Innenkörpers (25) endet.

8. Drehbare Rohrkathode nach Anspruch 1, **dadurch gekennzeichnet, dass** der Raum zwischen der Außenwand des Innenkörpers (25) und der Innenwand der zylindrischen und elastischen Folie (36) als Kühlmittelrückflussraum dient.

9. Drehbare Rohrkathode nach Anspruch 1, **dadurch gekennzeichnet, dass** die zylindrische und elastische Folie (36) aus Gummi, Kunststoff, Metall, Grafitfaser, Glasfaser oder aus Kombinationen dieser Stoffe besteht.

10. Drehbare Rohrkathode nach Anspruch 1, **dadurch gekennzeichnet, dass** die elastische Folie (36) an ihren Enden durch Kleben, Schweißen, Vulkanisieren oder über O-Ringe abgedichtet ist.

## Claims

1. Rotatable tube cathode for cathode sputtering, in which the tube cathode comprises a fluid cooling system and the fluid cooling means flows past the inner wall of a target or target carrier, **characterized in that** between the target carrier or the target (30) and the central longitudinal axis of the tube cathode (2) a cylindrical and elastic film (36) is provided.

2. Rotatable tube cathode as claimed in claim 1, **characterized in that** within the target (30) or target carrier at least one stationary magnet (44) is provided, which does not take part in the rotational movements of the tube cathode (2).

3. Rotatable tube cathode as claimed in claim 1, **characterized in that** the cylindrical and elastic film (36) encompasses an inner body (25), over which a cooling means is conducted.

4. Rotatable tube cathode as claimed in claim 1, **characterized in that** the cylindrical and elastic film (36) is connected with one flange (31, 33) at each of its two ends.

5. Rotatable tube cathode as claimed in claim 3, **characterized in that** the inner body (25) has a circular arc-form bottom (27), which is provided with holes (28, 29) for the passage of the cooling means.

6. Rotatable tube cathode as claimed in claim 5, **characterized in that** the circular arc-form bottom (27) supports magnets (44 to 46).

7. Rotatable tube cathode as claimed in claim 3, **characterized in that** a cooling means supply (4) in the form of a tube is provided, which extends from the side of the atmosphere into the inner body (25) and terminates shortly in front of a side wall (41) of the inner body (25).

8. Rotatable tube cathode as claimed in claim 1, **characterized in that** the space between the outer wall of the inner body (25) and the inner wall of the cylindrical and elastic film (36) serves as a cooling means flow-back space.

9. Rotatable tube cathode as claimed in claim 1, **characterized in that** the cylindrical and elastic film (36) is comprised of rubber, synthetic material, metal, graphite fiber, glass fiber or of combinations of these substances.

10. Rotatable tube cathode as claimed in claim 1, **characterized in that** the elastic film (36) is sealed off at its ends by adhesion, welding, vulcanization or via O-rings.

## Revendications

1. Cathode tubulaire tournante pour pulvérisation cathodique, la cathode tubulaire présentant un refroidissement au fluide et le fluide refroidisseur s'écoulant devant la paroi intérieure d'une cible ou d'un support de cible, **caractérisée en ce qu'**entre le support de cible ou la cible (30) et l'axe longitudinal central de la cathode tubulaire (2), il est prévu un film cylindrique et élastique (36).

2. Cathode tubulaire tournante selon la revendication 1, **caractérisée en ce qu'**à l'intérieur de la cible (30) ou du support de cible, il est prévu au moins un aimant stationnaire (44) qui ne suit pas les mouvements de rotation de la cathode tubulaire (2).

3. Cathode tubulaire tournante selon la revendication 1, **caractérisée en ce que** le film cylindrique et élastique (36) entoure un corps intérieur (25) au moyen duquel un refroidisseur est conduit.

4. Cathode tubulaire tournante selon la revendication 1, **caractérisée en ce que** le film cylindrique et élastique (36) est raccordé à ses deux extrémités respectivement à une bride (31, 33).

5. Cathode tubulaire tournante selon la revendication 3, **caractérisée en ce que** le corps intérieur (25) présente un fond en forme d'arc de cercle (27) qui est percé de trous (28, 29) pour laisser passer le refroidisseur.

6. Cathode tubulaire tournante selon la revendication 5, **caractérisée en ce que** le fond en forme d'arc de cercle (27) supporte des aimants (44 à 46).

7. Cathode tubulaire tournante selon la revendication 3, **caractérisée en ce qu'**il est prévu une conduite de refroidisseur (4) sous forme d'un tuyau qui, venant de l'atmosphère, arrive dans le corps intérieur (25) et se termine juste avant une paroi latérale (41) du corps intérieur (25).

8. Cathode tubulaire tournante selon la revendication 1, **caractérisée en ce que** l'espace entre la paroi extérieure du corps intérieur (25) et la paroi intérieure du film cylindrique et élastique (36) sert d'espace d'écoulement pour le refroidisseur.

9. Cathode tubulaire tournante selon la revendication 1, **caractérisée en ce que** le film cylindrique et élastique (36) est composé de caoutchouc, de matière plastique, de métal, de fibre de graphite, de fibre de verre ou de combinaisons de ces matières.

10. Cathode tubulaire tournante selon la revendication 1, **caractérisée en ce que** le film élastique (36) est étanchéifié à ses extrémités par collage, soudage, vulcanisation ou par des joints toriques.
